# EUROPEAN PATENT APPLICATION

(11) **EP 3 038 146 A1**
(43) Date of publication of application: **29.06.2016**
(21) Application number: 15202387.5
(22) Date of filing: 23.12.2015
(51) Int. Cl.: H01L 21/67, H01L 21/683

(54) **SUBSTRATE HOLDING ASSISTANT MEMBER AND SUBSTRATE TRANSFER APPARATUS**

(30) Priority: 26.12.2014 JP 2014265633
(71) Applicant: TOKYO ELECTRON LIMITED, Minato-ku Tokyo 107-6325 (JP)
(72) Inventor: Obikane, Tadashi, Yamanashi, 407-8511 (JP)
(74) Representative: Hoffmann Eitle

(57) **Abstract**

A substrate holding assistant member for assisting vacuum-suction of a substrate on a mounting table includes an upper covering wall portion and a side surrounding wall portion. The upper covering wall portion has intake holes or gas ejection holes for ejecting a gas toward the substrate and is configured to cover a space above the substrate mounted on the mounting table. The side surrounding wall portion is coupled to an outer peripheral portion of the upper covering wall portion and configured to cover a side of the substrate. A gap between an inner peripheral surface of the side surrounding wall portion and an outer peripheral side surface of the substrate is smaller than a gap between an uppermost portion of the substrate and a bottom surface of the upper covering wall portion.

## Description

### Field of the Invention

The disclosure relates to a substrate holding assistance member used when sucking and holding a substrate to be tested or processed, such as a semiconductor wafer or the like, on a mounting table, and a substrate transfer apparatus.

### Background of the Invention

A probe apparatus (hereinafter, referred to as "prober") is known as an apparatus for inspecting electrical characteristics of semiconductor devices formed on a semiconductor wafer (hereinafter, referred to as "wafer") as a substrate. For example, there is known a prober including a probe card having a predetermined number of probe needles to be brought into contact with one of the semiconductor devices formed on the wafer, and a stage which is movable horizontally and vertically while mounting thereon the wafer. The prober inspects electrical characteristics of the semiconductor devices by bringing the probe needles into contact with solder bumps or electrode pads of the semiconductor devices and allowing an inspection current to flow from the probe needles to the electrode pads or the solder bumps.

In the prober, the wafer is held on the stage by vacuum-suction so that the wafer is not moved thereon. Recently, the wafer may have large warpage due to its small thickness, and a high density or a complicated structure of semiconductor devices formed thereon.

Therefore, there are suggested various assistant units for vacuum-sucking a wafer having large warpage on a stage. For example, there is suggested a method for vacuum-sucking the wafer on the stage by correcting warpage of the wafer by ejecting a gas from a space above the wafer to a region that is not in contact with the stage (see, e.g. Japanese Patent Application Publication Nos. S61-276339 and 2000-243814).

However, in the assistant units of the vacuum-suction methods disclosed in Japanese Patent Application Publication Nos. S61-276339 and 2000-243814, it is difficult to suck the entire wafer on the stage especially in a case where the stage is warped in a U-shape and an outer peripheral portion of the wafer is separated from the stage while a central portion thereof is in contact with the stage.

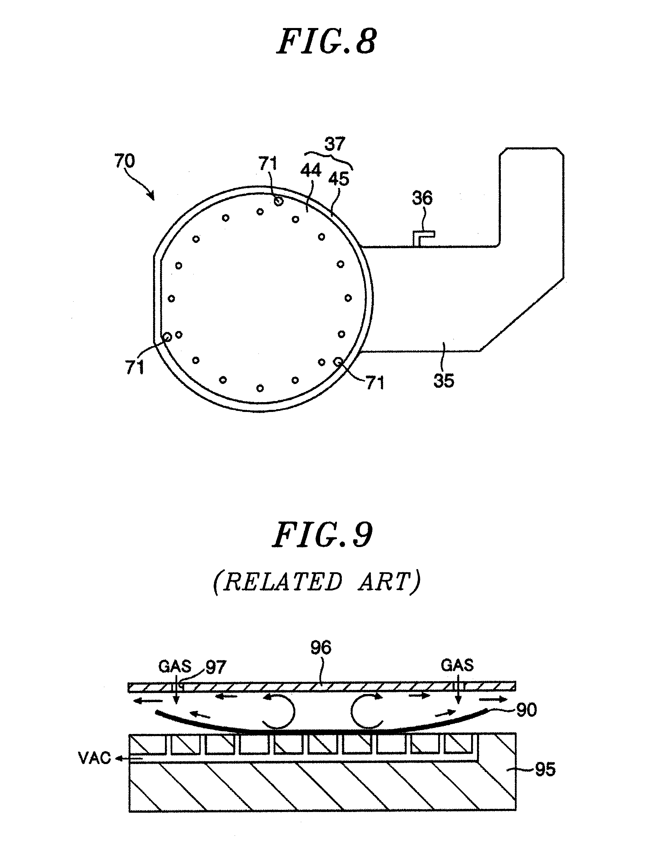

Fig. 9 schematically shows gas flow in the case of applying a conventional holding assistant method using gas ejection to a substrate having large warpage. A wafer 90 has U-shaped warpage protruding toward a stage 95. In the case of correcting the warpage by the conventional holding assistant method, the gas is ejected such that the outer peripheral portion of the wafer 90 is biased toward the stage 95 and becomes close to the stage 95.

However, if gas ejection holes 97 are made to be close to the wafer 90 (or a gas pressure is increased) to increase the biasing force of biasing the outer peripheral portion of the wafer 90 toward the stage 95, a dynamic pressure is increased at an outer peripheral side of a top surface of the wafer 90. Accordingly, a force of lifting the wafer 90 is generated and the wafer 90 becomes unstable. As a result, it is difficult to vacuum-suck the wafer 90.

In the example shown in Fig. 9, a plate-shaped member 96 having the gas ejection holes 97 is disposed to face the wafer 90. The same result is obtained by ejecting a gas onto the top surface of the outer peripheral portion of the wafer 90 by using a nozzle (not shown) instead of the plate-shaped member 96.

### Summary of the Invention

In view of the above, the disclosure provides a substrate holding assistant member and a substrate transfer apparatus that can vacuum-suck a substrate on a mounting table even when a substrate has large warpage.

In accordance with a first aspect of the present invention, there is provided a substrate holding assistant member for assisting vacuum-suction of a substrate on a mounting table, including an upper covering wall portion having intake holes or gas ejection holes for ejecting a gas toward the substrate and configured to cover a space above the substrate mounted on the mounting table; and a side surrounding wall portion coupled to an outer peripheral portion of the upper covering wall portion and configured to cover a side of the substrate, wherein a gap between an inner peripheral surface of the side surrounding wall portion and an outer peripheral side surface of the substrate may be smaller than a gap between an uppermost portion of the substrate and a bottom surface of the upper covering wall portion.

In the above described substrate holding assistant member, when the upper covering wall portion has the gas ejection holes, the gas ejection holes may be formed at a portion of the upper covering wall portion which faces the outer peripheral portion of the substrate mounted on the mounting table.

In the above described substrate holding assistant member, when the upper covering wall portion has the intake holes, a total opening area of the intake holes may be equal to or greater than a gas flow area between a top surface of the substrate and the bottom surface of the upper covering wall portion.

In the above described substrate holding assistant member, the intake holes may be formed at a portion of the upper covering wall portion which faces the outer peripheral portion of the substrate mounted on the mounting table.

In accordance with a second aspect of the present invention, there is provided a substrate transfer apparatus including, a substrate holding assistant member configured to assist vacuum-suction of a substrate on a mounting table; a moving unit configured to move the substrate holding assistant member; and a control unit configured to control movement of the substrate holding assistant member by the moving unit, wherein the substrate holding assistant member may include an upper covering wall portion having gas ejection holes for ejecting a gas toward the substrate and configured to cover a space above the substrate mounted on the mounting table; and a side surrounding wall portion coupled to an outer peripheral portion of the upper covering wall portion and configured to cover a side of the substrate, wherein the control unit may control the moving unit such that the substrate holding assistant member is disposed at a specified position where a gap smaller than a maximum warpage amount of the substrate is formed between a bottom surface of the side surrounding wall portion and a top surface of the mounting table when the substrate mounted on the mounting table is vacuum-sucked on the mounting table, and wherein when the substrate holding assistant member is disposed at the specified position, a gap between an inner peripheral surface of the side surrounding wall portion and an outer peripheral side surface of the substrate may be smaller than a gap between an uppermost portion of the substrate and a bottom surface of the upper covering wall portion.

In the above described substrate transfer apparatus, the gas ejection holes may be formed at a portion of the upper covering wall portion which faces the outer peripheral portion of the substrate mounted on the mounting table.

In accordance with a third aspect of the present invention, there is provided a substrate transfer apparatus including, a substrate holding assistant member configured to assist vacuum-suction of a substrate on a mounting table; a moving unit configured to move the substrate holding assistant member; and a control unit configured to control movement of the substrate holding assistant member by the moving unit, wherein the substrate holding assistant member may include an upper covering wall portion having intake holes and configured to cover a space above the substrate mounted on the mounting table; and a side surrounding wall portion coupled to an outer peripheral portion of the upper covering wall portion and configured to cover a side of the substrate, wherein the control unit may control the moving unit such that the substrate holding assistant member is disposed at a specified position where a bottom surface of the side surrounding wall portion is brought into close contact with a top surface of the mounting table when the substrate mounted on the mounting table is vacuum-sucked on the mounting table, and wherein when the substrate holding assistant member is disposed at the specified position, a gap between an inner peripheral surface of the side surrounding wall portion and an outer peripheral side surface of the substrate may be smaller than a gap between an uppermost portion of the substrate and a bottom surface of the upper covering wall portion.

In the above described substrate transfer apparatus, a total opening area of the intake holes may be equal to or greater than an area of a gas channel between a top surface of the substrate and the bottom surface of the upper covering wall portion.

In the above described substrate transfer apparatus, the intake holes may be formed at a portion of the upper covering wall portion which faces the outer peripheral portion of the substrate mounted on the mounting table.

In the above described substrate transfer apparatus, the substrate holding assistant member may include a position detection sensor configured to detect a position of the substrate mounted on the mounting table, and the control unit may control movement of the substrate holding assistant member by the moving unit such that the side surrounding wall portion is not brought into contact with the substrate based on the position of the substrate which is detected by the position detection sensor.

In the disclosure, even if the substrate as a processing target mounted on the mounting table has a portion separated from the top surface of the mounting table due to the warpage, the flow of the gas supplied to the space above the substrate to assist the vacuum-suction of the substrate on the mounting table is controlled such that a force of pressing the portion separated from the surface of the mounting table toward the mounting table is generated. Accordingly, even the substrate having large warpage can be reliably vacuum-sucked on the mounting table.

### Brief Description of the Drawings

The objects and features of the disclosure will become apparent from the following description of embodiments, given in conjunction with the accompanying drawings, in which:
Fig. 1 is a perspective view showing a schematic configuration of a prober;
Fig. 2 is a perspective view showing a schematic structure of a stage of the prober shown in Fig. 1 and a driving mechanism for moving the stage;
Figs. 3A and 3B are a perspective view showing a schematic configuration of a wafer transfer unit provided at a loader of the prober shown in Fig. 1 and a perspective view showing a partial cross section of a holding assistant arm according to a first embodiment, respectively;
Fig. 4 shows a cross sectional view of a cover member and the stage, which explains a state that the holding assistant arm shown in Figs. 3A and 3B assists a vacuum-suction of the wafer on the stage;
Figs. 5A and 5B are a perspective view showing a schematic structure of a holding assistant arm according to a second embodiment and a perspective view showing a partial cross section of the holding assistant arm, respectively;
Fig. 6 is a cross sectional view of a cover member and the stage, which explains a state that the holding assistant arm shown in Figs. 5A and 5B assists a vacuum-suction of the wafer on the stage;
Fig. 7A and 7B are a bottom view showing a schematic structure of a holding assistant arm according to a third embodiment and a cross sectional view of a cover member and the stage, which explains a state that the holding assistant arm assists a vacuum-suction of the wafer on the stage, respectively;
Fig. 8 is a bottom view showing a schematic structure of a holding assistant arm according to a fourth embodiment; and
Fig. 9 schematically illustrates gas flow in the case of applying a conventional holding assistant method using gas ejection to a substrate having large warpage.

### Detailed Description of the Embodiments

Hereinafter, embodiments will be described with reference to the accompanying drawings. Here, as a substrate processing apparatus, for example a prober for inspecting electrical characteristics of semiconductor devices formed on a wafer as a processing target substrate is discribed.

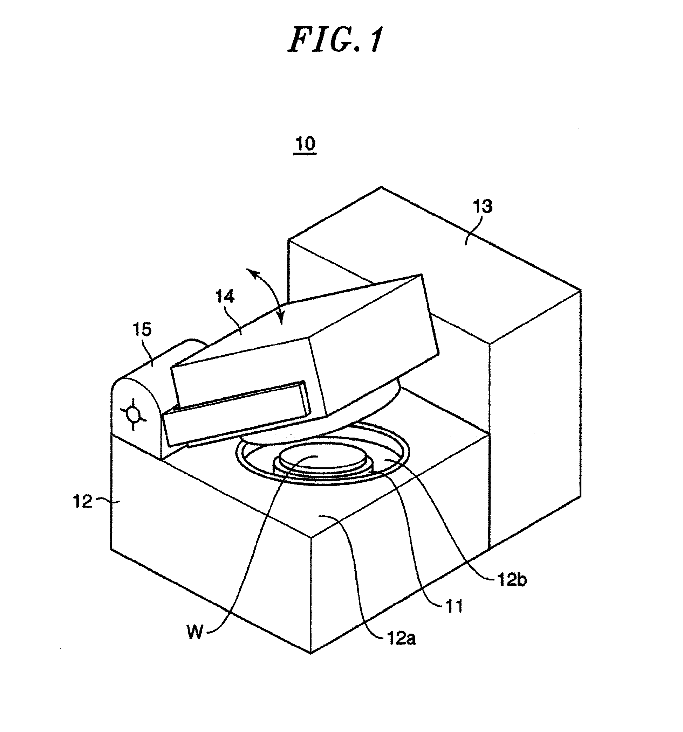

Fig. 1 is a perspective view showing a schematic configuration of a prober 10. The prober 10 includes: a main body 12 having therein a stage 11 (mounting table) for mounting thereon a wafer W, a loader 13 provided close to the main body 12, and a test head 14 (inspection unit) provided to cover the main body 12. The prober 10 inspects electrical characteristics of semiconductor devices formed on a wafer having a large diameter, e.g., of about 300 mm (300 mmϕ) or 450 mm (450 mmϕ).

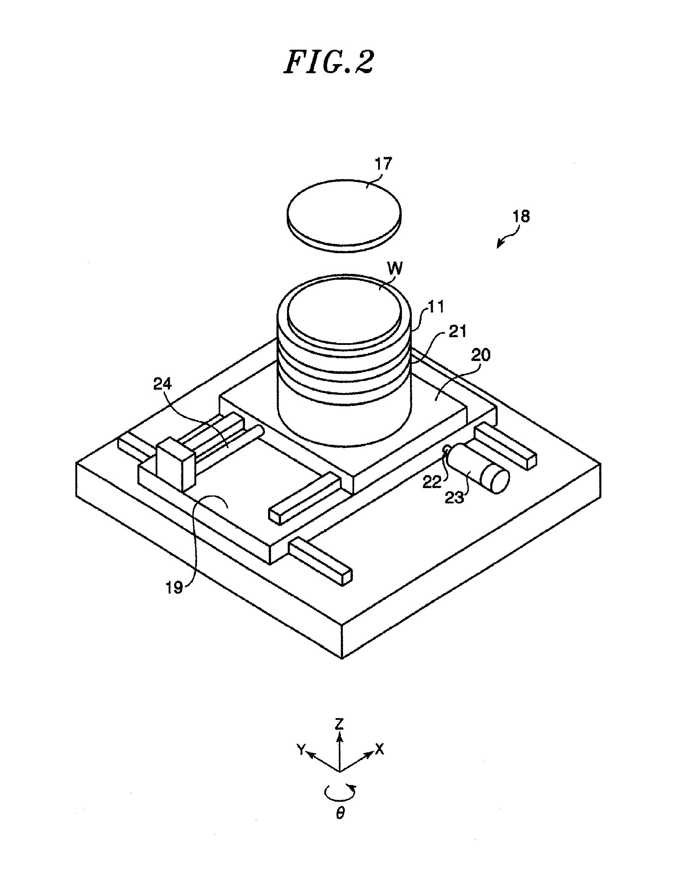

The main body 12 is formed in a housing shape having a hollow inner space. Formed at a ceiling portion 12a of the main body 12 is an opening 12b that opens above the wafer W mounted on the stage 11. A probe card 17 (see Fig. 2) to be described later is disposed at the opening 12b to face the wafer W mounted on the stage 11. The wafer W is vacuum-sucked at a predetermined position on the stage 11.

The test head 14 has a rectangular parallelepiped shape and is configured to be pivotable in up-down direction by a hinge unit 15 provided on the main body 12. When covering the main body 12, the test head 14 is electrically connected to the probe card 17 through a contact ring (not shown). Further, the test head 14 includes a data storage unit (not shown) for storing, as measurement data, electrical signals indicating electrical characteristics of semiconductor devices which are transmitted from the probe card 17, and a determination unit (not shown) for determining whether or not the semiconductor devices on the wafer W as an inspection target have electrical defects based on the measurement data.

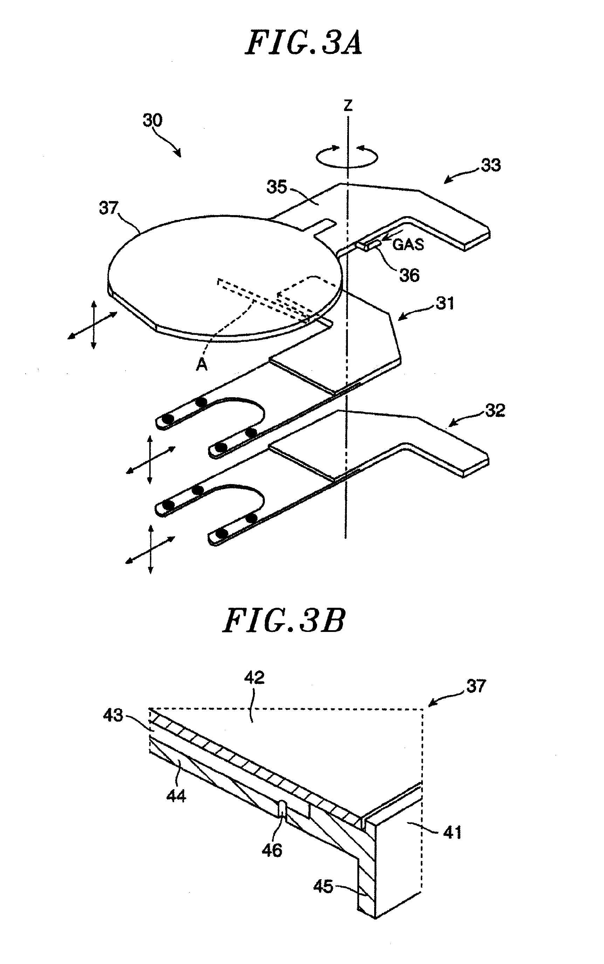

The loader 13 includes a container mounting stage (not shown) for mounting thereon a FOUP or MAC (not shown) as a transfer container of the wafer W. Provided at the loader 13 is a wafer transfer unit including a loading arm and an unloading arm for transfering the wafer W to and from the transfer container mounted on the container mounting table and loading and unloading the wafer W to and from the stage 11. The wafer transfer unit further includes a holding assistant arm for assisting vacuum-suction of the wafer W on the stage 11. The wafer transfer unit will be described later with reference to Fig. 3.

A plurality of probe needles (not shown) is arranged on a bottom surface of the probe card 17 to correspond to solder bumps or electrode pads of the semiconductor devices of the wafer W. The stage 11 allows the electrode pads or the like of the semiconductor devices to be in contact with the probe needles by controlling relative positions of the probe card 17 and the wafer W.

When the probe needles are brought into contact with the electrode pads or the like of the semiconductor devices, the test head 14 allows an inspection current to flow to the semiconductor devices via the probe needles of the probe card 17 and then transmits the electrical signals indicating the electrical characteristics of the semiconductor devices to the data storage unit of the test head 14. The data storage unit of the test head 14 stores the transmitted electrical signals as the measurement data. The determination unit determines whether or not the semiconductor devices as inspection targets have electrical defects based on the stored measurement data.

The probe needles of the probe card 17 need to be provided at positions corresponding to the positions of solder bumps or electrode pads of the semiconductor devices formed on the wafer W as an inspection target. Therefore, the probe card 17 is configured to be exchangable depending on types of semiconductor devices formed on the wafer W as an inspection target.

Fig. 2 is a perspective view showing a schematic configuration of a driving mechanism for moving the stage 11 of the prober 10. As shown in Fig. 2, the moving unit 18 for moving the stage 11 includes a Y stage 19 movable along the Y direction in Fig. 2, an X stage 20 movable along the X direction in Fig. 2, and a Z moving unit 21 movable along the Z direction in Fig. 2.

The Y stage 19 is driven with high accuracy in the Y direction by rotation of a ball screw 22 extending along the Y direction. The ball screw 22 is rotated by a Y stage motor 23 that is a step motor. The X stage 20 is driven with high accuracy in the X direction by rotation of a ball screw 24 extending along the X direction. The ball screw 24 is rotated by an X stage motor (not shown) that is a step motor. The stage 11 is movable on the Z moving unit 21 along a θ direction in Fig. 2 by a θ rotation motor 23 (not shown). The wafer W is mounted on the stage 11.

The semiconductor devices formed on the wafer W are made to face the probe card 17 by cooperation of the Y stage 19, the X stage 20, the Z moving unit 21 and the stage 11, so that the electrode pads or the like of the semiconductor devices can be brought into contact with the probe needles. The Y stage motor 23, the X stage motor, and the θ rotation motor are controlled by a motor controller (not shown).

Fig. 3A is a perspective view showing a schematic configuration of the wafer transfer unit 30 provided at the loader 13. The wafer transfer unit 30 includes a loading arm 31 and an unloading arm 32 that are spaced from each other at a predetermined interval in the Z-axis direction, and a holding assistant arm 33 according to the first embodiment.

The loading arm 31, the unloading arm 32, and the holding assistant arm 33 are rotatable about the Z-axis by a rotation driving unit (not shown), movable back and forth in a direction perpendicular to the Z-axis by a linear driving unit (not shown), and vertically movable in a direction parallel to the Z-axis by an elevation unit (not shown). The Z-axis is parallel to the vertical direction. The rotation driving unit, the linear driving unit and the elevation unit are collectively refered to as a moving unit.

The loading arm 31 is used for taking out the wafer W from the transfer container and mounting the wafer W on the stage 11. The unloading arm 32 is used for unloading the wafer W that has been subjected to the inspection of electrical characteristics of the semiconductor devices from the stage 11 and accommodating the wafer W in the transfer container. The structures of the loading arm 31 and the unloading arm 32 are not directly related to the disclosure, so that the detailed description thereof will be omitted. However, it is preferable to use, as the loading arm 31 and the unloading arm 32, arms disclosed in, e.g., Japanese Patent Application Publication No. 2014-135363, which has a suction mechanism and a suction portion for vacuum-sucking the wafer W in order to reliably hold the wafer W even if it is warped.

The holding assistant arm 33 serves as a substrate holding assistant member for assisting vacuum-suction of the wafer W on the stage 11. By providing the holding assistant arm 33 at the wafer transfer unit 30, scaling-up of the prober 10 can be avoided. The holding assistant arm 33 includes a base 35, a gas inlet port 36 provided at the base 35, and a cover member 37 attached to the base 35.

Fig. 3B is a perspective view showing a partial cross section A of the cover member 37 shown in Fig. 3A. The cover member 37 substantially includes a cover base 41 and a circular plate member 42 attached to the top surface of the cover base 41. The cover base 41 includes: a circular plate-shaped upper covering wall portion 44 for covering the space above the wafer W mounted on the stage 11; and a ring-shaped side surrounding wall portion 45 coupled to an outer peripheral portion of the upper covering wall portion 44, for covering the side of the wafer W mounted on the stage 11. The cover base 41 is made of, e.g., aluminum.

A disc-shaped recess is formed on the top surface of the upper covering wall portion 44. By airtightly covering the recess with the circular plate member 42, a gas channel 43 is formed in the cover base 37. The gas channel 43 communicates with a gas channel (not shown) formed at the base 35 to communicate with the gas inlet port 36. A plurality of gas ejection holes 46 communicating with the gas channel 43 is formed at the upper covering wall portion 44. Therefore, when a gas is supplied from a gas supply unit (not shown) to the holding assistant arm 33 through the gas inlet port 36, the supplied gas flows through the gas channel 43 and then is ejected toward the wafer W mounted on the stage 11 from the gas ejection holes 46. The gas ejection holes 46 spaced apart from each other at a regular interval are arranged to face the outer peripheral portion of the wafer W in a state where the wafer W mounted on the stage 11 is covered by the cover member 37.

An inner diameter of the side surrounding wall portion 45 is set to a value that allows a predetermined gap to be formed between the side surrounding wall portion 45 and the outer peripheral side surface of the wafer W without contact therebetween in a state where the wafer W mounted on the stage 11 is covered by the cover member 37. For example, in the case of the holding assistant arm 33 provided at the prober 10 for inspecting a wafer of 300 mmΦ, the inner diameter of the side surrounding wall portion 45 may be set to 305 mmΦ. As will be described later, the inner diameter of the side surrounding wall portion 45 is not limited to 305 mmΦ as long as it is possible to obtain the holding assistant effect when the wafer W having warpage is vacuum-sucked on the stage 11.

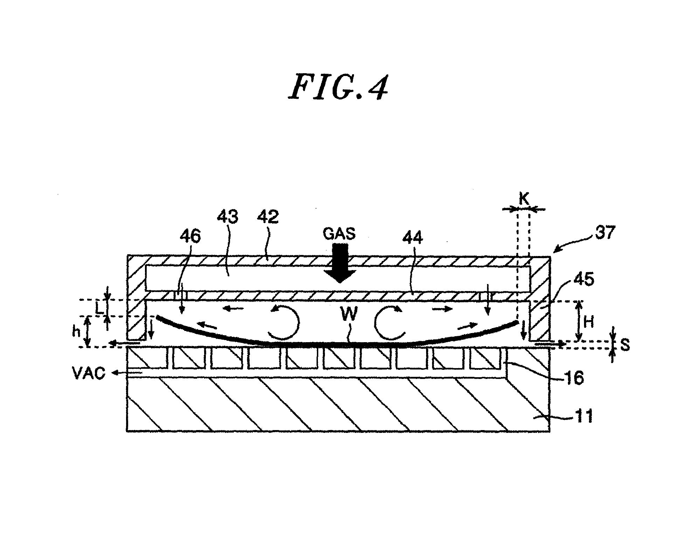

Fig. 4 is a cross sectional view of the stage 11 and the cover member 37, which explains a state that the holding assistant arm 33 assist the vacuum-suction of the wafer W on the stage 11. In Fig. 4, the illustration of the structure of the cover member 37 is simplified.

When the wafer W held on the loading arm 31 is mounted on the stage 11 and the loading arm 31 is retreated from the space above the stage 11, the cover member 37 of the holding assistant arm 33 provided at the wafer transfer unit 30 is positioned immediately above the stage 11. Then, vacuum-suction (VAC) is started through vacuum-suction holes 16 of the stage 11 so that vacuum-suction on the top surface of the stage 11 is started. At this time, the central portion of the wafer W is vacuum-sucked on the stage 11, but the outer peripheral portion of the wafer W is separated from the stage 11 due to the downwardly protruding U-shaped warpage of the wafer W.

The cover member 37 is lowered toward the stage 11 from the space immediately above the stage 11 and held at a specified position where a predetermined gap S is formed between a bottom surface of the side surrounding wall portion 45 and a top surface of the stage 11. The gap S is set to be smaller than a maximum warpage amount h of the wafer W, e.g., about 2 mm. A height H of the side surrounding wall portion 45 is set in consideration of the gap S and the maximum warpage amount h of the wafer W such that the relationship "H+S>h" is satisfied, i.e., such that the cover member 37 is not in contact with the wafer W. A gap K between the outer peripheral side surface of the wafer W and the inner peripheral surface of the side surrounding wall portion 45 of the cover member 37 is set to be smaller than a gap L between an uppermost portion of the wafer W and the bottom surface of the upper covering wall 44 (K<L).

The gas ejection from the gas ejection holes 46 toward the wafer W may be started when the cover member 37 starts to lower toward the stage 11 or after the position of the cover member 37 is determined. When the gas is ejected from the gas ejection holes 46 toward the outer peripheral portion of the wafer W, a static pressure at the top surface of the wafer W is increased because the space above the wafer W is covered by the upper covering wall portion 44 and the outer peripheral side of the wafer W is surrounded by the side surrounding wall portion 45. Accordingly, the force of pressing the wafer W toward the stage 11 can be increased. Further, since the gap K between the outer peripheral side surface of the wafer W and the inner peripheral surface of the side surrounding wall portion 45 is set to be smaller than the minimum gap L between the uppermost portion of the wafer W and the bottom surface of the upper covering wall portion 44, the flow velocity of the gas flowing through the gap K is increased and a dynamic pressure is increased. As a consequence, the force of pressing the outer peripheral portion of the wafer W toward the stage 11 can be increased. The static pressure at the space below the bottom surface of the wafer W (space surrounded by the bottom surface of the wafer W, the top surface of the stage 11, and the side surrounding wall portion 45) can be decreased by discharging, from the gap S, the gas flowing through the gap K between the outer peripheral side surface of the wafer W and the inner peripheral surface of the side surrounding wall portion 45. As a result, the force of attracting the wafer W toward the stage 11 can be increased. By cooperation of the forces, the wafer W having large U-shaped warpage can be corrected to a flat state and reliably sucked and held on the stage 11.

Whether or not the wafer W is sucked and held on the stage 11 can be determined based on changes in the pressure of vacuum-suction at the stage 11. This is because, when the wafer W is sucked and held on the stage 11, the amount of gas sucked from the vacuum-suction holes 16 of the stage 11 becomes extremely small and, thus, a vacuum level is increased. If it is determined that the wafer W is sucked and held on the stage 11, the gas supply to the gas inlet port 36 is stopped and the cover member 37 is retreated from the space above the stage 11. Then, the wafer W is inspected by using the probe card 17.

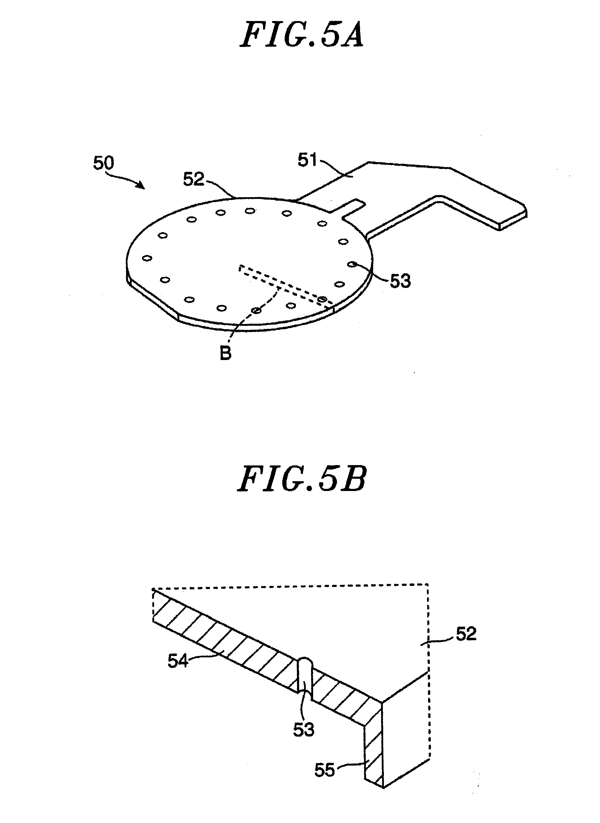

Next, a structure of a holding assistant arm according to a second embodiment and its usage method will be described with reference to Figs. 5A to 6. Fig. 5A is a perspective view showing a schematic structure of a holding assistant arm 50 according to the second embodiment. Fig. 5B is a perspective view showing a partial cross section B of a cover member 52 shown in Fig. 5A.

The holding assistant arm 50 is used instead of the holding assistant arm 33 of the wafer transfer unit 30 shown in Figs. 3A and 3B. The holding assistant arm 50 includes a base 51, and the cover member 52 attached to the base 51. The cover member 52 has an upper covering wall portion 54 and a ring-shaped side surrounding wall portion 55 coupled as one unit to an outer periphery of the upper covering wall portion 54. A plurality of intake holes 53 spaced apart from each other at a predetermined gap is formed at a portion of the upper covering wall portion 54 which faces the outer peripheral portion of the wafer W in a state where the wafer W mounted on the stage 11 is covered by the cover member 52. An inner diameter of the side surrounding wall portion 55 is equal to that of the side surrounding wall portion 45 of the cover member 37.

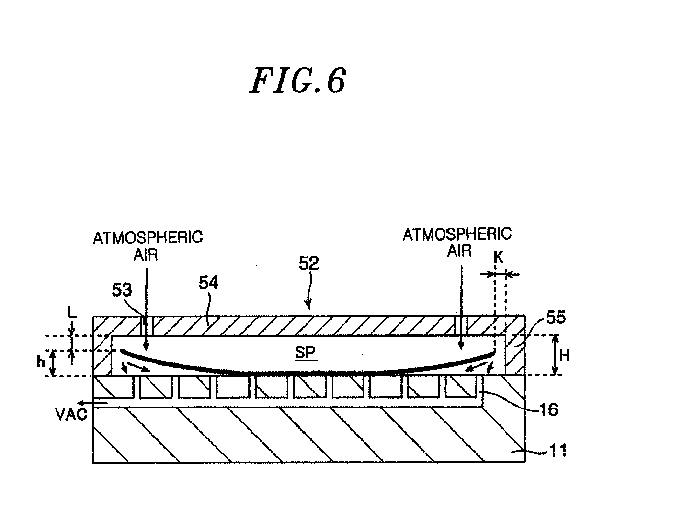

Fig. 6 is a cross sectional view of the stage 11 and the cover member 52, which explains a state that the holding assistant arm 50 assists a vacuum-suction of the wafer W on the stage 11 by the holding assistant arm 50. In Fig. 6, the illustration of the structure of the cover member 52 is simplified.

The cover member 52 is lowered toward the stage 11 from the space immediately above the stage 11 and held at a specified position where the bottom surface of the side surrounding wall portion 55 and the top surface of the stage 11 are brought into contact with each other. At this time, the height H of the side surrounding wall portion 55 is set to be greater than a maximum warpage amount h of the wafer W (H>h) so that the cover member 52 is not brought into contact with the wafer W. The gap K between the outer peripheral side surface of the wafer W and the inner peripheral surface of the side surrounding wall portion 55 of the cover member 52 is set to be smaller than the minimum gap L (=H-h) between the uppermost portion of the wafer W and the bottom surface of the upper covering wall portion 54 (K<L).

When vacuum-suction VAC is started through the vacuum-suction holes 16 formed at the stage 11, the central portion of the wafer W is vacuum-sucked on the stage 11 and the outer peripheral portion of the wafer W is separated from the stage 11 due to the downwardly protruding U-shaped warpage of the wafer W, as can be seen from Fig. 6. Therefore, atmospheric air in the space SP defined by the top surface of the stage 11 and the cover member 52 is sucked from the vacuum-suction holes 16 formed at the outer peripheral portion of the stage 11. Accordingly, air (atmospheric air) in the outside flows toward the wafer W through the intake holes 53 formed at the upper covering wall portion 54. The air introduced into the space SP passes through a gap formed between the wafer W and the cover member 52 and then is discharged through the vacuum-suction holes 16 formed at the outer peripheral portion of the stage 11.

At this time, due to the air introduced into the space SP from the intake holes 53, a static pressure at the top surface of the wafer W is increased so that the outer peripheral portion of the wafer W is biased toward the top surface of the stage 11. Further, since the gap K between the outer peripheral side surface of the wafer W and the inner peripheral surface of the side surrounding wall portion 55 is set to be smaller than the minimum gap L between the uppermost portion of the wafer W and the bottom surface of the upper covering wall portion 54, the flow velocity of the gas flowing through the gap K is increased and the dynamic pressure is increased. As a consequence, the force of pressing the outer peripheral portion of the wafer W toward the stage 11 can be increased and the static pressure of the space below the bottom surface of the wafer W (space surrounded by the bottom surface of the wafer W, the top surface of the stage 11, and the side surrounding wall portion 55) can be decreased. By cooperation of the forces, even the wafer W having large U-shaped warpage can be corrected to a flat state and reliably sucked and held on the stage 11.

In order to suck and hold the wafer W on the stage 11 by using the holding assistant arm 50, air that is enough to generate a force of biasing the outer peripheral portion of the wafer W toward the surface of the stage 11 needs to flow into the space SP through the intake holes 53. In order to ensure such an inflow amount of the air, a total opening area of the intake holes 53 is set to be equal to or greater than a gas flow area between a top surface of the wafer W and the bottom surface of the upper covering wall portion 54.

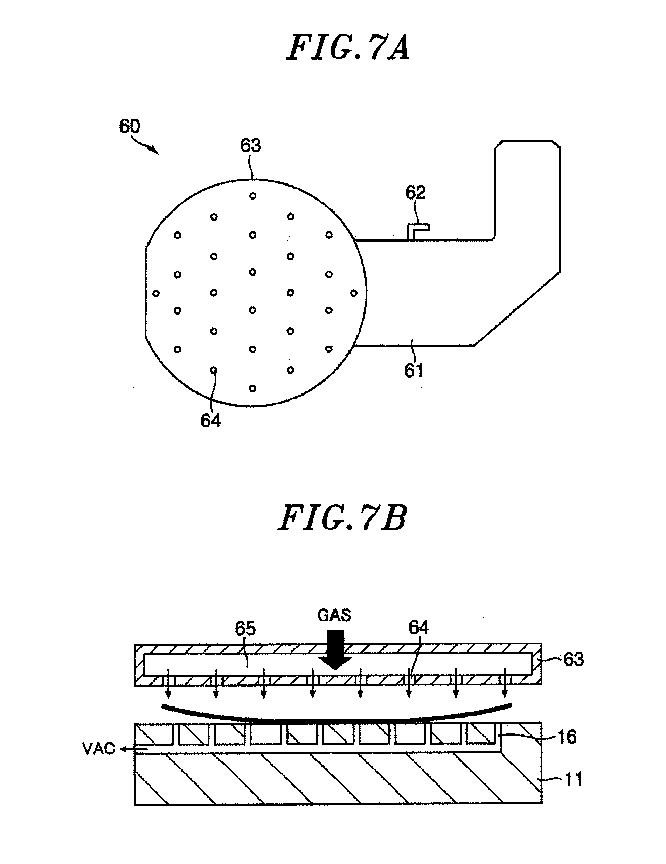

Next, a structure of a holding assistant arm according to a third embodiment and its usage method will be described with reference to Figs. 7A and 7B. Fig. 7A is a bottom view showing a schematic structure of a holding assistant arm 60 according to the third embodiment. Fig. 7B is a cross sectional view of the stage 11 and the cover member 63, which explains a state that the holding assistant arm 60 assists a vacuum-suctionof the wafer W on the stage 11.

The holding assistant arm 60 includes a base 61, gas inlet holes 62 provided at the base 61, and a cover member 63 attached to the base 61. A gas channel 65 is formed in the cover member 63, as in the case of the gas channel 34 formed in the cover member 37 of the holding assistant arm 33 according to the first embodiment. The gas channel 65 communicates with the gas inlet holes 62 formed at the base 61. A plurality of gas ejection holes 64 spaced apart from each other at a substantially regular interval is formed at the entire surface of a lower wall portion of the cover member 63 which faces the top surface of the stage 11 when the cover member 63 is disposed above the stage 11. When the gas is supplied to the holding assistant arm 60 through the gas inlet holes 62, the supplied gas flows through the gas channel 65 and then is ejected toward the wafer W mounted on the stage 11 from the gas ejection holes 64.

When the cover member 63 is disposed to face the wafer W mounted on the stage 11 with a predetermined gap therebetween and vacuum-suction VAC is started through the vacuum-suction holes 16 formed at the stage 11, the central portion of the wafer W is vacuum-sucked on the stage 11, but the outer peripheral portion of the wafer W is separated from the stage 11 due to the downwardly protruding U-shaped warpage of the wafer W, as can be seen from Fig. 7B.

Next, the gas is ejected from the gas ejection holes 64 to the wafer W. Due to the ejection of the gas to the entire top surface of the wafer W, the static pressure of the space between the top surface of the wafer W and the cover member 63 is increased. Accordingly, the wafer W is pressed toward the top surface of the stage 11 and thus can be sucked and held on the top surface of the stage 11. At this time, the force of pressing the outer peripheral portion of the wafer W toward the stage 11 can be increased by reducing a gap between the bottom surface of the cover member 63 and the uppermost portion of the wafer W. For example, as the wafer W is corrected to a flat state, the cover member 63 may become close to the wafer W without contact therewith.

Next, a structure of a holding assistant arm according to a fourth embodiment will be described with reference to Fig. 8. Fig. 8 is a bottom view showing a schematic structure of a holding assistant arm 70 according to the fourth embodiment. The holding assistant arm 70 has a structure in which position detection sensors 71 for detecting misalignment between the wafer W and the stage 11 are added to the holding assistant arm 33 according to the first embodiment. Therefore, the reference numerals of the components of the holding assistant arm 70 are the same as those of the components of the holding assistant arm 33, and redundant description thereof will be omitted.

The position detection sensors 71 may be provided at any portion of the holding assistant arm 70 as long as they can detect the position of the wafer W. In this example, the position detection sensors 71 are provided at an outer peripheral side of the upper covering wall portion 44. A small camera is suitable for the position detection sensors 71. The controller of the wafer transfer unit 30 controls the horizontal position of the cover member 37, based on the position of the wafer W which is detected by the position detection sensors 71, such that the side surrounding wall portion 45 of the cover member 37 and the wafer W are not brought into contact with each other when the holding assistant arm 33 is lowered. Although three position detection sensors 71 are illustrated in the drawing, the number of the position detection sensors 71 is not limited thereto and may be one or two, or more than three.

In the holding assistant arm 70 provided at the prober 10 for inspecting the wafer W of, e.g., 300 mmϕ, when the side surrounding wall portion 45 has an inner diameter of 305 mmϕ as in the case of the holding assistant arm 33, the gap K of 2.5 mm (see Fig. 4) is formed between the outer peripheral end of the wafer W and the inner peripheral surface of the side surrounding wall portion 45. In order to press the entire wafer W toward the stage 11, it is preferable that the gap K is uniformly formed along the entire circumference of the wafer W (i.e., the outer periphery of the wafer W and the inner periphery of the side surrounding wall portion 45 are coaxially disposed). The wafer W having warpage is not stable on the stage 11 and may be deviated from a reference position on the stage 11. When the wafer W is greatly deviated from the reference position, the wafer W may be damaged by the contact with the bottom surface of the side surrounding wall portion 45 of the cover member 37 during the operation of lowering the cover member 37 toward the stage 11.

Therefore, the cover member 37 is positioned to a predetermined position (see Fig. 4) close to the stage 11 while detecting the position of the wafer W by the position detection sensors 71 or after the position of the wafer W is detected by the position detection sensors 71 such that the wafer W is not brought into contact with the side surrounding wall portion 45 and more preferably such that the gap K between the outer peripheral end of the wafer W and the inner peripheral surface of the side surrounding wall portion 45 is uniform along the entire circumference of the wafer W. Accordingly, it is possible to prevent the wafer W from being damaged by the contact with the side surrounding wall portion 45. Further, the gap K between the outer peripheral end of the wafer W and the inner peripheral surface of the side surrounding wall portion 45 can become uniform along the entire circumference of the wafer W.

As described above, the above-described various holding assistant arms according to the embodiments enable the wafer W having large warpage to be sucked and held on the stage 11. The holding assistant arms can also be effectively used for vacuum-suction of the wafer W having a warpage amount that is increased when it is mounted on the stage 11.

For example, in the prober 10, the stage may be heated to and maintained at a measurement temperature in advance in order to inspect the wafer W that has been heated to and maintained at a predetermined temperature in consideration of an increase of a temperature during usage of the semiconductor devices formed on the wafer W. Recently, a wafer W used for inspection using the prober 10 may have resin, glass or the like molded on the semiconductor devices on the wafer. Since the thermal conductivity of resin or glass is different from that of silicon forming the wafer, when the wafer W is mounted on the stage heated to and maintained at the predetermined temperature, the wafer W has warpage and amount of an original warpage of the wafer W is increased. Accordingly, it is difficult to vacuum-suck the wafer W on the stage.

It is possible to suppress the increase in the warpage amount of the wafer W when mounting the wafer W on the stage 11 by means of mounting, sucking and holding the wafer W on the stage having a decreased temperatureand, thereafter increasing the temperature of the stage. However, in that case, an inspection time for a single wafer W is increased (throughput is decreased). On the other hand, in the case of using the holding assistant arms according to the embodiments, the wafer W can be vacuum-sucked on the stage 11 without decreasing the temperature of the stage. Therefore, even in the case of inspecting the wafer W having large warpage, the throughput of the prober 10 is not decreased.

While the embodiments have been described, the disclosure is not limited thereto. For example, in the prober 10, the stage 11 may be heated to and maintained at the measurement temperature by using a temperature control function in order to perform the inspection in a state where the wafer W is heated to and maintained at a predetermined temperature corresponding to an operating temperature of semiconductor devices as an inspection target. Therefore, in the case of using the holding assistant arms 33, 60 and 70, it is preferable to eject a gas heated to a predetermined temperature to the wafer W so that the temperature of the wafer W is not decreased. The supply method of the heated gas is not particularly limited. The gas heated to the predetermined temperature may be supplied to the gas inlet ports 36 and 62. Altenativley, a heater may be provided in a gas channel in each of the holding assistant arms 33, 60 and 70 to heat an introduced gas.

In the cover members 37 of the holding assistant arms 33 and 70, the gas ejection holes 46 are arranged to face the outer peripheral portion of the wafer W. However, the position of the gas ejection holes 46 is not limited thereto. As in the case that the gas ejection holes 64 are formed at the bottom surface of the cover member 63 of the holding assistant arm 60, the gas ejection holes may be formed at the upper covering wall portion 44 of the cover base 41 of the cover member 37 so as to uniformly eject a gas to the entire surface of the wafer W.

In the above-described embodiments, the prober for inspecting electrical characteristics of the semiconductor devices formed on the wafer W is employed as the substrate processing apparatus. However, the disclosure is not limited thereto and may also be applied to an apparatus for performing predetermined processing on a vacuum-sucked wafer W, e.g., a plasma processing apparatus or the like.

While the disclosure has been shown and described with respect to the embodiments, it will be understood by those skilled in the art that various changes and modifications may be made without departing from the scope of the disclosure as defined in the following claims.

## Claims

1. A substrate holding assistant member for assisting vacuum-suction of a substrate on a mounting table, comprising:
an upper covering wall portion having intake holes or gas ejection holes for ejecting a gas toward the substrate and configured to cover a space above the substrate mounted on the mounting table; and
a side surrounding wall portion coupled to an outer peripheral portion of the upper covering wall portion and configured to cover a side of the substrate,
wherein a gap between an inner peripheral surface of the side surrounding wall portion and an outer peripheral side surface of the substrate is smaller than a gap between an uppermost portion of the substrate and a bottom surface of the upper covering wall portion.

2. The substrate holding assistant member of claim 1, wherein when the upper covering wall portion has the gas ejection holes, the gas ejection holes are formed at a portion of the upper covering wall portion which faces the outer peripheral portion of the substrate mounted on the mounting table.

3. The substrate holding assistant member of claim 1, wherein when the upper covering wall portion has the intake holes, a total opening area of the intake holes is equal to or greater than a gas flow area between a top surface of the substrate and the bottom surface of the upper covering wall portion.

4. The substrate holding assistant member of claim 3, wherein the intake holes are formed at a portion of the upper covering wall portion which faces the outer peripheral portion of the substrate mounted on the mounting table.

5. A substrate transfer apparatus comprising:
the substrate holding assistant member described in claim 1 or 2;
a moving unit configured to move the substrate holding assistant member; and
a control unit configured to control movement of the substrate holding assistant member by the moving unit,
wherein the upper covering wall portion has the gas ejection holes,
wherein the control unit controls the moving unit such that the substrate holding assistant member is disposed at a specified position where a gap smaller than a maximum warpage amount of the substrate is formed between a bottom surface of the side surrounding wall portion and a top surface of the mounting table when the substrate mounted on the mounting table is vacuum-sucked on the mounting table, and
wherein when the substrate holding assistant member is disposed at the specified position, a gap between an inner peripheral surface of the side surrounding wall portion and an outer peripheral side surface of the substrate is smaller than a gap between an uppermost portion of the substrate and a bottom surface of the upper covering wall portion.

6. A substrate transfer apparatus comprising:
the substrate holding assistant member described in any one of claims 1, 3 and 4;
a moving unit configured to move the substrate holding assistant member; and
a control unit configured to control movement of the substrate holding assistant member by the moving unit,
wherein the upper covering wall portion has the intake holes,
wherein the control unit controls the moving unit such that the substrate holding assistant member is disposed at a specified position where a bottom surface of the side surrounding wall portion is brought into close contact with a top surface of the mounting table when the substrate mounted on the mounting table is vacuum-sucked on the mounting table, and
wherein when the substrate holding assistant member is disposed at the specified position, a gap between an inner peripheral surface of the side surrounding wall portion and an outer peripheral side surface of the substrate is smaller than a gap between an uppermost portion of the substrate and a bottom surface of the upper covering wall portion.

7. The substrate transfer apparatus of claim 5 or 6, wherein the substrate holding assistant member includes a position detection sensor configured to detect a position of the substrate mounted on the mounting table, and
the control unit controls movement of the substrate holding assistant member by the moving unit such that the side surrounding wall portion is not brought into contact with the substrate based on the position of the substrate which is detected by the position detection sensor.
